(19) Europäisches Patentamt
European Patent Office
Office européen des brevets

(11) **EP 4 246 162 B1**

(12) **EUROPEAN PATENT SPECIFICATION**

(45) Date of publication and mention
of the grant of the patent:
**10.07.2024 Bulletin 2024/28**

(21) Application number: **22163101.3**

(22) Date of filing: **18.03.2022**

(51) International Patent Classification (IPC):
**G01R 31/392** $^{(2019.01)}$

(52) Cooperative Patent Classification (CPC):
**G01R 31/392**

(54) **METHOD OF ESTIMATION OF BATTERY DEGRADATION**

VERFAHREN ZUR SCHÄTZUNG DER BATTERIEVERSCHLECHTERUNG

PROCÉDÉ D'ESTIMATION DE DÉGRADATION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**20.09.2023 Bulletin 2023/38**

(73) Proprietor: **ABB Schweiz AG
5400 Baden (CH)**

(72) Inventors:
• **Sowa, Kacper
33-342 Barcice (PL)**
• **Ruszczyk, Adam
30-316 Kraków (PL)**
• **Nieto, Carlos
75301 Jüri, Rae vald (EE)**

(74) Representative: **Wroblewski, Marcin Jan
Fert, Jakubiak vel Wojtczak
Wróblewski rzecznicy patentowi
Sp. P. / ul. Gdanska 126/A103
90-520 Lodz (PL)**

(56) References cited:
EP-A1- 3 531 149          EP-B1- 3 273 523
WO-A1-2021/044134          CN-A- 111 753 416
US-A1- 2011 288 691          US-A1- 2017 115 358
US-A1- 2018 156 873          US-A1- 2021 263 105
US-B1- 10 942 223

## Description

### Field of the Invention

The invention relates to a method of estimation of battery degradation, in particular battery degradation in battery energy storage systems (BESS). The method is suitable for the estimation of degradation of any kind of battery, notably Li-Ion battery in battery energy storage systems (BESS) designated to support energy distribution or energy flow of power systems, in particular power systems with high dynamic loads.

### Description of Prior Art

Nowadays plenty of devices and applications require to store electric energy in different forms of storages. It entails either balancing of instantaneous energy consumption over a defined period (peak shaving) or mobile usage of devices like eg. portable one or electric vehicles.

The most popular are electrochemical batteries especially Li-Ion type due to the highest energy density per volume or mass and practically lack of memory effect. Nevertheless, chemical batteries degrade over time and during their use. The main consequence of the degradation is decrease of its internal energy capacity (Wh) and increase of equivalent serial resistance (ESR).

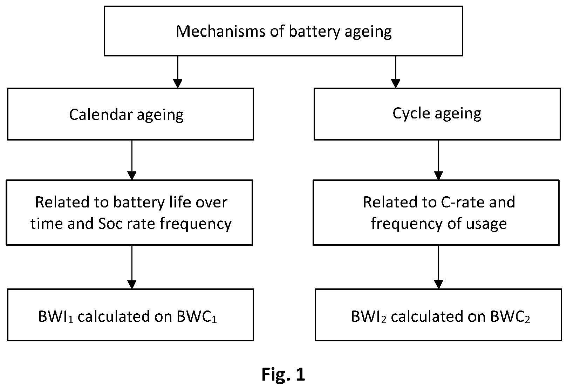

There are two main mechanisms of batteries ageing, as depicted in Fig. 1. Calendar ageing, related to battery longevity conditioned by SoC level kept on a battery over time and cycle ageing - related to C-rate and number of charging cycles (discharge and charge sessions). The temperature of the battery is an additional ageing factor that has an influence either on the calendar ageing as well as on the cycle ageing. However, in the specific application of batteries in the battery energy storage systems (BESS) temperature parameters can be omitted since the batteries the battery energy storage systems (BESS) operate in stable temperature 22-25 °C provided by air-conditioning systems.

It is very important - from exploitation, scheduled maintenance, or investment point of view - to be able to judge battery wearing progress and remaining lifespan, defining how long battery may stay in service. In consequence the initial investment cost, operation cost, cost of service, maintenance schedule and certainty of device with battery can be calculated. However, it is very difficult, due to various chemical compositions, different structures, and exploitation conditions.

Battery manufacturers can predict the lifetime of their products based on their experience in cells designing and manufacturing. The battery manufacturers have knowledge about the mechanism of battery structure degradation and data of battery survivability collected in the laboratory or in-field application (e.g. mobile phone batteries statistics).

However, such lifetime predictions are done assuming standard conditions such as State of Charge (SoC), Depth of Discharge (DoD), charge/discharge rate (C-rate), number of performed cycles, ambient conditions such as temperature and/or humidity and others. Nonetheless, users of the batterie cannot always keep the same operation condition due to varying ambient conditions or utilization needs. Therefore, manufacturers define battery life in a number of charge/discharge cycles assuming the single full cycle is charging and discharging to one defined Depth of Discharge with a nominal C-rate. If one cycle per day is assumed the total lifetime of the battery can be calculated.

Therefore, a number of non-destructive methods helping to judge battery degradation have been elaborated. Most of them use a simple measurement of electrical parameters (e.g. ESR). Some more advanced use thermography or radiography.

Furthermore, in many cases, manufacturers and/or vendors of batteries are forcing on batteries users an execution of the State of Health (SoH) procedure at least once per year for warranty purposes. The goal of the State of Health (SoH) procedure is to investigate the true capacity of the battery, recalibrate SoC and update battery lifetime estimation. The procedure usually is as follow:

    a. discharging batteries to minimum
    b. 15 min of rest
    c. charging to maximum
    d. 15 min of rest
    e. discharging to minimum

The SoC recalibration procedure is required to mark the battery degradation degree, calculate, and set trendlines for the predicted remaining battery lifespan. It means that this method takes into consideration only the averaged degradation process of the battery in the past period. The described approach cannot distinguish so-called "cycle ageing" or "calendar ageing" as the root cause for battery degradation.

The drawback of this approach is that the expected lifetime is always assumed for typical exploitation conditions and cannot be treated as the advice for the utilization model of the battery for its lifetime optimization.

Furthermore, in some specific applications the controlled, forced discharge is impossible, eg. in the BESS applications where BESS is not allowed to discharge to the grid. The discharge process (speed, time and depth of discharge) is affected by external load demand. Moreover, it is expected that BESS is 24h/7days in service (maintenance periods limited to the absolute minimum).

A patent application CN111753416A discloses a lithium-ion battery RUL (Remaining useful life) prediction method based on two-stage Wiener process. A two-stage Wiener process-based lithium-ion battery RUL prediction method comprises the following steps:

S1: Collecting historical degradation data of lithium-ion batteries;
S2: Estimating the change point of each lithium-ion battery according to the historical degradation data of the lithium-ion battery;
S3: Estimating the hyperparameters based on the EM algorithm based on the data obtained by the estimation of the change point of the lithium-ion battery;
S4: Collecting lithium-ion battery operation monitoring data to determine whether the change point appear;
S5: Updating the model parameters according to the lithium-ion battery operation monitoring data;
S6: Estimating the RUL of the lithium-ion battery based on the data obtained from the change point estimation and the hyperparameter estimation;
S7: Collecting the latest degradation data and put it into the degradation data set;
S8: Repeating steps S4 to S7 to update the model parameters until the lithium-ion battery fails.

A patent application EP3824305A1 reveals a method for determining a maximum duration of use of a battery comprising: selecting a period of use of the battery; obtaining values of degradation factors of the battery during the period of use; determining one or more ageing indicators of the battery based upon the values of degradation factors; identifying intervals of variation of the values of degradation factors during said period of use, each of the one or more ageing indicators being associated with actual intervals of variation which each comprise a minimum value and a maximum value of said degradation factors; and predicting the maximum duration of use based upon the intervals of variation, the one or more ageing indicators, and at least one operating limit of the battery.

Furthermore, a patent application US20170115358A1 reveals a computer implemented method for determining battery degradation including both calendar and cycle ageing characteristics of the battery. The method comprises the step of: collecting, by the computer, individual battery cycling and calendar ageing data including daily charge/discharge profiles; estimating, by the computer, a primary battery capacity for the individual cycling and calendar ageing; evaluating, by the computer, the individual cycling and calendar ageing stability; combining the individual cycling and calendar ageing into an integrated degradation function for the given battery over its entire lifetime by an iterative process starting with a combined original battery capacity, cap(n) which is the battery original capacity minus original cycling and calendar ageing values; and outputting the integrated degradation function.

Moreover, a patent application WO2021044134A1 discloses a method and system for predicting battery degradation. The method comprises measuring a set of variables for a battery; selecting parameters for a degradation model which predicts degradation of the battery and which comprises a calendar ageing component and a cycling ageing component; predicting a predicted degradation value for the battery using the degradation model and the selected parameters; obtaining an estimated degradation value for the battery using the set of measured variables; updating the parameters for the degradation model based on the predicted and estimated degradation values and outputting a final degradation value based on the estimated and predicted degradation values.

A patent application EP3531149A4 reveals an apparatus and a method for estimating capacity retention ratio of secondary battery. A method for estimating a capacity retention rate of a secondary battery included in a battery pack from a degree of calendar ageing and a degree of cycle ageing of the secondary battery, the method comprising: receiving current information and temperature information of the secondary battery from a sensing unit installed in the battery pack in each cycle having a preset time length; activating a first main process; and activating a second main process, wherein the first main process includes: a first subprocess for updating a state of charge of the secondary battery based on the current information; a second subprocess for setting an operation state of the secondary battery to one of cycle state and calendar state based on the current information; a third subprocess for updating a degree of cycle ageing based on the updated state of charge, the current information and the temperature information when the operation state of the secondary battery is set to the cycle state by the second subprocess; and a fourth subprocess for updating a degree of calendar ageing based on the updated state of charge and the temperature information when the operation state of the secondary battery is set to the calendar state by the second subprocess, and the second main process includes estimating the capacity retention rate of the secondary battery based on a predetermined weighting factor, the updated degree of cycle ageing and the degree of calendar ageing.

Furthermore, a patent application EP3273523B1 discloses an apparatus and a method for estimating degree of ageing of secondary battery. The method of estimating a degree of ageing of a secondary battery, the method comprising: (a) determining a current and a temperature of the secondary battery by using a current measuring unit and a temperature measuring unit; (b) determining a state of charge of the secondary battery from the current of the secondary battery; (c) determining an operation state of the secondary battery as one of a calendar state and a cycle state by using the current of the secondary battery; (d) determining a predefined degree-of-calendar-ageing profile corresponding to the determined state of charge and the determined temperature while the secondary battery is in the calendar state, and determining a degree of calendar ageing in the calendar state by applying a cumulative degree-of-ageing model to the determined degree-of-calendar-ageing profile; (e) determining a predefined degree-of-cycle-ageing profile corresponding to the determined state of charge, the determined temperature, and the determined current of the secondary battery while the secondary battery is in the cycle state, and determining a degree of cycle ageing in the cycle state by applying the cumulative degree-of-ageing model to the determined degree-of-cycle-ageing profile; and (f) determining, as the degree of ageing of the secondary battery, a weighted average value that is calculated for the determined degree of calendar ageing and the determined degree of cycle ageing on the basis of calendar time for which the calendar state is maintained and cycle time for which the cycle state is maintained.

## The essence of the invention

The object of the invention is to provide a method allowing for estimating battery degradation of any kind of battery, notably Li-Ion battery in a battery energy storage system (BESS), taking into consideration actual operating conditions of battery.

The object of the invention is realized by computer-implemented method of estimating battery degradation comprising the steps of:

a) acquiring battery parameters, characteristics of calendar ageing wearing coefficient $BWC_1$ and/or characteristics of cycle ageing wearing coefficient $BWC_2$ wherein $BWC_1$ is a function of State of Charge (SoC) and $BWC_2$ is a function of charging/dis-charging rate (C-rate),

b) acquiring and/or calculating instantaneous values of SoC and C-rate of a battery in a defined period,

c) reading instantaneous values of calendar ageing wearing coefficient $BWC_1$ and/or instantaneous values of cycle ageing wearing coefficient $BWC_2$ corresponding to instantaneous values of SoC and C-rate of a battery acquired in step (b), using characteristics of ageing wearing coefficients acquired in step (a), and

d) determining:

- value of calendar ageing wearing index $BWI_1$ by referring integrated instantaneous values of $BWC_1$ determined in step (c) to the integrated instantaneous values of $BWC_1$ for a period of nominal operation time with maximum allowable value of the SoC, and/or

- values of cycle ageing wearing index $BWI_2$ by referring integrated instantaneous values of $BWC_2$ determined in step (c) to the integrated instantaneous values of $BWC_2$ for full battery charging (from $SoC_{min}$ to $SoC_{max}$) or discharging (from $SoC_{max}$ to $SoC_{min}$) with nominal C-rate

thereby indicating degree of battery degradation.

Preferably, the method further comprises a step of determining a total current value of battery wearing index BWI according to equation (E8),

$$BWI = [k \cdot BWI_1 + (1 - k) \cdot BWI_2] \qquad (8)$$

wherein:

k - weight of calendar ageing wearing index $BWI_1$ (for 0 < k < 1)
(1-k) - weight of calendar ageing wearing index $BWI_2$.

Beneficially, instantaneous values of SoC and C-rate of a battery are acquired from predicted SoC and C-rate profiles based on historical data.

It is also beneficial that the characteristics of calendar ageing wearing coefficient $BWC_1$ and/or the characteristics of cycle ageing wearing coefficient $BWC_2$ are frequently updated.

Preferably, the characteristics of calendar ageing wearing coefficient $BWC_1$ and/or characteristics of cycle ageing wearing coefficient $BWC_2$ are tuned using machine learning (ML) algorithms, wherein historical data of the battery operation is used as input data for ML algorithms.

During battery operation data are collected. These data are input for ML that can tune BWC characteristics to better reflect wearing process of battery. What improves battery lifespan prediction (estimation of the battery degradation).

For battery lifespan prediction, beneficially is, when instantaneous values of calendar ageing wearing coefficient BWC1 and/or instantaneous values of cycle ageing wearing coefficient BWC2 are determined for a period of 24 hours.

Preferably, the characteristics of calendar ageing wearing coefficient $BWC_1$ and characteristics of cycle ageing wearing coefficient $BWC_2$ of the battery are determined based on battery parameters declared by battery manufacturer.

Usefully, the steps of the method being performed by means of a processing employing artificial intelligence and/or machine learning techniques and/or at least one trained algorithm.

Preferably said method is employed for estimating battery degradation of a Li-Ion battery.

Preferably said method is employed for estimating battery degradation in a battery energy storage system (BESS). Furthermore, it is beneficial that the step of acquiring battery parameters also acquiring operating parameters of a battery energy storage system (BESS).

The object of the invention is also a computer program comprising means of program code for performing all steps of the computer-implemented estimating method when said program is running on the computer.

The object of the invention is also a computer-readable medium storing computer-implemented instructions performing all steps of the computer-implemented estimating method implemented on the computer.

## Advantages of the Invention

The characteristic of calendar ageing wearing coefficient $BWC_1$ and characteristics of cycle ageing wearing coefficient $BWC_2$ defines instantaneous battery wearing intensity for current operation condition. The characteristics of $BWC_1$ and $BWC_2$ provide information on wearing speed depending on battery's actual exploitation condition.

The values of calendar ageing wearing index $BWI_1$ and cycle ageing wearing index $BWI_2$ indicate a degree of battery degradation in all systems with Li-Ion batteries, in particular, battery energy storage systems (BESS).

The total current value of battery wearing index BWI relates to degree of battery degradation integrating both mechanisms of batteries ageing, including the significance of each of them for battery ageing.

Results of the method can be used for optimization of the operation of a battery energy storage system (BESS) for setting charging/dis-charging C-rate and State of Charge that leads to slower wearing. Moreover, developed method can point out the optimal battery energy storage system (BESS) operating conditions, which will affect batteries lifetime in minimum level.

## Description of Figures

The object of the invention is shown in embodiments in a drawing, in which:

Fig. 1    - shows mechanism of Li-Ion batteries ageing,

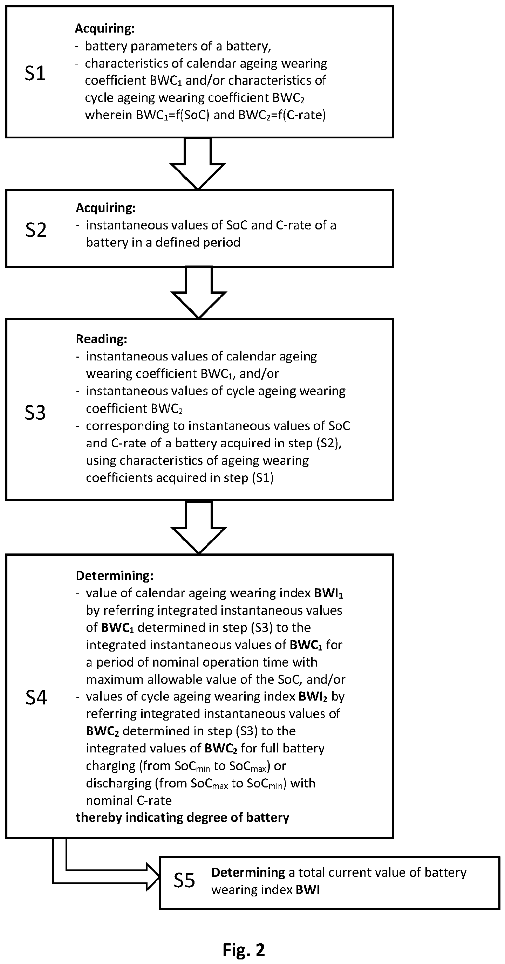

Fig. 2    - schematically shows a method of estimating battery degradation according to the invention,

Fig. 3    - shows example characteristic of the battery wear coefficient $BWC_1$ in function of SoC values,

Fig. 4    - shows example characteristic of the battery wear coefficient $BWC_2$ in function of C-rate values,

## Notation and nomenclature

Some parts of the detailed description which is given below are presented as part of procedures, steps of data processing, or other symbolic representations of operations on binary data that can be performed in the computer memory. Therefore, logical steps are performed by the computer, which requires physical manipulation of physical quantities. Typically, these values take the form of electrical or magnetic signals that are suitable for storage, transmission, connection, comparison or other ways of manipulation of data in a computer system. Due to widespread use, these data are referred to as signals, time courses, bits, packets, messages, values, elements, symbols, signs, terms, numbers and the like. In addition, all of these terms, or the like, should be identified with their corresponding physical quantities, and are merely convenient terms for these physical quantities. Terms such as "processing" or "creating", or "sending", or "performing", or "determining", or "detecting", or "receiving", or "selecting", or "calculating", or "generating", or similar, refer to activities and processes of a computer system that manipulates and transforms data represented as physical (electronic) quantities in registers and computer memories into other data similarly represented as physical quantities in memories or registers, or other information storages. The computer-readable medium (memory) as defined herein may typically be non-volatile and/or include a non-volatile device. In this context, the non-volatile storage medium may include a device which may be material, which means that the device has a specific physical form, although the device may change its physical state. Thus, for example, the term non-volatile refers to the device remaining material, although it changes its state.

In addition, data regarding SoC, C-rate, or other quantities, processed by the described method, refer each time to physical measurement and/or predicted data representing the actual operating environment of the battery. In the case of simulation data, there is actually a battery statistically corresponding to this data.

**Description of the Invention**

Method of estimating battery degradation

In step S1 of a computer-implemented method of estimating battery degradation in a battery energy storage system (BESS), battery parameters, characteristics of calendar ageing wearing coefficient $BWC_1$ and/or characteristics of cycle ageing wearing coefficient $BWC_2$ are acquired S1 from the memory of a battery management system (BMS).

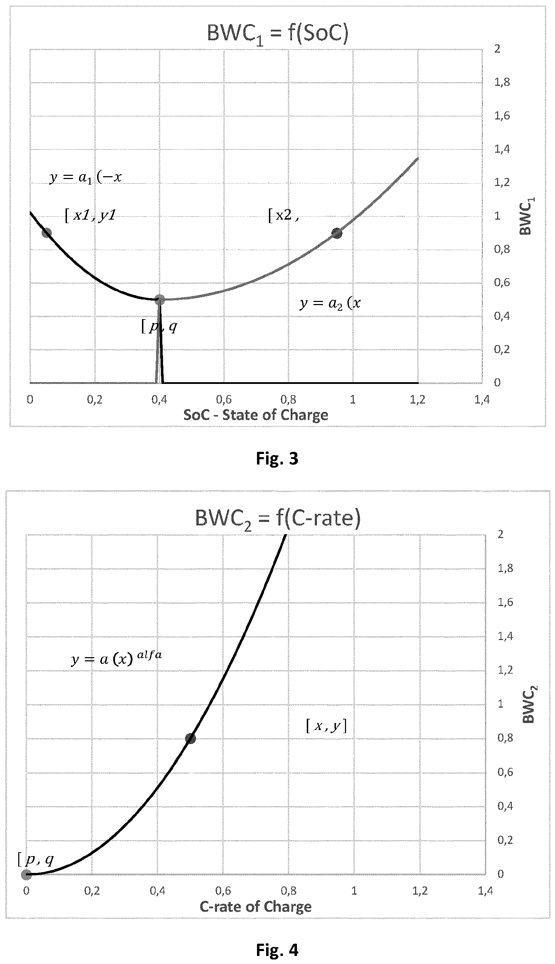

The BWC characteristic defines instantaneous battery wearing intensity for current operation condition of the battery. The BWC characteristics as show on Fig. 3 and Fig. 4 give the information about wearing speed depends on battery's exploitation condition. This information can be also used for optimization of a selection of charging/dis-charging C-rate and State of Charge that leads to slower wearing. The initial characteristics of calendar ageing wearing coefficient $BWC_1$ and/or characteristics of cycle ageing wearing coefficient $BWC_2$ are based on battery type, basic parameters of the battery declared by its manufacturer, as well as recommendations of the manufacturer. Example of battery parameters of a battery acquired in step S1 are shown in Table 1.

Table 1. Basic data used for generation of BWCs characteristics.

| No. | Index | Value | Short name | Description |
|---|---|---|---|---|
| 1 | $SoC_{storage}$ | 40% | The battery state of charge during long time store | Optimal or recommended *State_of_Charge* of battery being long time stored. The charge that ensures the battery will be stored with minimal decrease of its initial capacity |
| 2 | $SoC_{min}$ | 5% | Minimum state of charge | Recommended minimal *State_of_Charge* remaining in battery considered as the end of discharge. Threshold that never should be crossed to not damage the battery |
| 3 | $SoC_{max}$ | 95% | Maximum state of charge | Recommended maximum *State_of_Charge* of the battery considered as the end of charge. Threshold that never should be crossed to not damage the battery |
| 4 | DoD | 90% | Depth of Discharge | Discharge in one cycle from Max to Min *State_of_Charge* |
| 5 | $t_{store}$ | 15 years | The store time | How long the battery can be stored on the shelf kept in their optimal storage condition (eg. ensured $SoC_{storage}$, temperature, humidity, mechanical stress) |
| 6 | $t_{life}$ | 5 years | The life span | How long it is expected the battery can work to their end of life |
| 7 | $N_{cycles}$ | 3000 | The number of cycles | How may full cycles of charge and discharge of the battery can be done during its whole life. |
| 8 | *C-rate* | 1 | Charge current | Recommended nominal charge/discharge current ratio (for 1 hour). The C-rate is calculated as rated charge/ discharge current over-rated capacitance of battery (A/Ah or W/Wh) |

The calendar ageing wearing coefficient $BWC_1$ relates to "calendar ageing" and is based on the SoC. The

function binding $BWC_1$ to actual value of SoC (BWC1=$f$(SoC)), has been shown in Fig. 3. The characteristics of the calendar ageing wearing coefficient $BWC_1$ can be determined by equation (1)

$$BWC_1 = f(SoC) = \begin{cases} a_1 \left(-x + p\right)^{alfa\_1} + q, & x < SoC_{storage} \\ a_2 \left(x - p\right)^{alfa\_2} + q, & x \geq SoC_{storage} \end{cases} \quad (1)$$

wherein:

x - value of SoC - the argument of the function (1)
p - storage SoC (SoC$_{storage}$) - the argument of minimum value of the function (1)
q - quotient of an expected operation time ($t_{life}$) of the battery over the nominal storage time ($t_{store}$) declared by battery vendor/manufacturer - minimum value of the function (1) set for the argument x = p alfa_1 - slope coefficient of the curve (alfa_1 >= 1)
alfa_2 - slope coefficient of the curve (alfa_2 >= 1)
a1 - mathematic coefficient of canonical form of the quadratic equation satisfying condition when function (1) passes through the reference point [$x_1$, $y_1$] and point [p, q]
a2 - mathematic coefficient of canonical form of the quadratic equation satisfying condition when function (1) passes through the reference point [$x_2$, $y_2$] and point [p, q]

The lowest value of calendar ageing wearing coefficient $BWC_1$ presented on Fig. 3 is set for SoC value recommended by manufacturer for storing batteries (SoC$_{storage}$) e.g. 40%. In turn, points [$x_1$, $y_1$] and [$x_2$, $y_2$] relates to values of $BWC_1$ corresponding to the SoC of the battery discharged to minimum or charged to maximum. Those points are determined on the basis of the battery manufacturer's data. Coefficients $a_1$, $a_2$ can be defined by equation (2) and equation (3).

$$a_1 = \frac{(DoD/100 - q)}{(-(1-DoD/100)/2 + p)^{alfa\_1}} \quad (2)$$

$$a_2 = \frac{(DoD/100 - q)}{(1 - (1-DoD/100)/2 - p)^{alfa\_2}} \quad (3)$$

The values of *alfa_1* and *alfa_2* for the initial characteristics of $BWC_1$ is set 2 and the calendar ageing wearing coefficient $BWC_1$ is thereby described by quadratic function equation.
In turn, the ageing wearing coefficient $BWC_2$ relates to "cycle ageing" and is based on the actual value of C-rate. The function binding $BWC_2$ to actual value of C-rate (BWC$_2$=$f$(C-rate)), has been shown in Fig. 4. The characteristics of the cycle ageing wearing coefficient $BWC_1$ can be determined by equation (4).

$$y = a \left(x\right)^{alfa} \quad (4)$$

wherein:

x-value of SoC
alfa - slope coefficient of the curve (>0)
a - mathematic coefficient of the quadratic equation satisfying condition when function (4) passes through the reference point [x, y]

The value of *alfa* of the initial characteristics of $BWC_2$ is equal 2 and that ageing wearing coefficient is described by quadratic function equation. The smallest value of $BWC_2$ coefficient is for C-rate equal to "0", when current doesn't flow, and operating cycles are no performed. In turn point [x,y] relates point of nominal wearing. That point is determined on the basis of the battery manufacturer's data.
Coefficients a can be defined by equation (5).

$$a = \frac{BWC_{nominal\,wearing}}{(C-rate_{nominal\,wearing})^{alpha}} \tag{5}$$

The characteristics of calendar ageing wearing coefficient $BWC_1$ and/or characteristics of cycle ageing wearing coefficient $BWC_2$ are frequently updated with the use of ML algorithms or AI. Historical data of the battery operation is used as an input data for ML algorithms. In particular, values of *alfa* can be modified using ML algorithms in order the curves better reflect wearing process of battery.

Mentioned Machine Learning (ML) mechanism is subject to n-dimensional space, in which each successive factor influencing the battery life is one of the n dimensions of space. In this example, 2-dimensional space is considered. However, in the other embodiments more factors influencing the battery life can be considered, like e.g. temperature, air humidity, atmospheric pressure, mechanical deformation, mechanical stress; reactive gases (e.g. ozone); cosmic radiation.

In the next step S2 instantaneous values of SoC and C-rate of a battery for a defined period (e.g. one day - 24 hours) are acquired and/or calculating. In the event of a need for calculation SoC and C-rate values from measured data (eg. battery current), it can be done with well-known methods for the person skilled in the art.

In some embodiments instantaneous values of SoC and C-rate of a battery are acquired from predicted SoC and C-rate profiles based on historical data. Prediction of such profiles is performed by means of a processing employing artificial intelligence and/or machine learning techniques and/or at least one trained algorithm upon historical data of power profiles of a power system comprising said battery.

Then read S3 the instantaneous values of calendar ageing wearing coefficient $BWC_1$ and/or instantaneous values of cycle ageing wearing coefficient $BWC_2$ corresponding to instantaneous values of SoC and C-rate of a battery in a battery energy storage system (BESS) acquired in step S2, using characteristics of ageing wearing coefficients acquired in step S1 is performed.

After that the value of calendar ageing wearing index $BWI_1$ is determined S4 by referring integrated instantaneous values of $BWC_1$ determined in step S3 to the integrated instantaneous values of $BWC_1$ for a period of expected operation time with maximum allowable value of the SoC ($SoC_{max}$). The ageing wearing index $BWI_1$ is defined by an equation (6).

$$BWI_1 = \frac{\int BWC_{SoC(t)}\,dt}{\int_0^{tlife} BWC_{SoCmax}\,dt} * 100\% \tag{6}$$

In step S4 also values of cycle ageing wearing index $BWI_2$ is determined by referring integrated instantaneous values of $BWC_2$ determined in step S3 to the integrated instantaneous values of $BWC_2$ for full battery charging (from $SoC_{min}$ to $SoC_{max}$) or discharging (from $SoC_{max}$ to $SoC_{min}$) with nominal C-rate. The ageing wearing index $BWI_1$ is defined by an equation (7).

$$BWI_2 = \frac{\int BWC_{C-rate(t)}\,dt}{2 \cdot N_{max\_cycles} \int_{SoC_{min}}^{SoC_{max}} BWC_{C-rate}\,dt} * 100\% \tag{7}$$

wherein:

$N_{cycles}$ - the number of full battery charging (from $SoC_{min}$ to $SoC_{max}$) or discharging (from $SoC_{max}$ to $SoC_{min}$) cycles declared by manufacturer

The values of calendar ageing wearing index $BWI_1$ and cycle ageing wearing index $BWI_2$ indicate a degree of battery degradation.

Optionally, in next step S5 a total current value of battery wearing index BWI can be determined according to equation (8),

$$BWI = [k \cdot BWI_1 + (1-k) \cdot BWI_2] \tag{8}$$

wherein:

k - weight of calendar ageing wearing index $BWI_1$ (for 0 < k < 1)
(1-k) - weight of calendar ageing wearing index $BWI_2$.

The total current value of battery wearing index BWI relates to degree of battery degradation in integrating both mechanisms of batteries ageing, including the significance of each of them for battery ageing.

Furthermore, all step of said method can be performed by means of a processing employing artificial intelligence and/or machine learning techniques and/or at least one trained algorithm.

## Claims

1. Computer-implemented method of estimating battery degradation, in particular, battery in a battery energy storage system, BESS, comprising the steps of:

   a) acquiring (S1) battery parameters of a battery, characteristics of calendar ageing wearing coefficient $BWC_1$ and/or characteristics of cycle ageing wearing coefficient $BWC_2$ wherein $BWC_1$ is a function of State of Charge, SoC, and $BWC_2$ is a function of charging/dis-charging rate, C-rate,
   b) acquiring and/or calculating (S2) instantaneous values of SoC and C-rate of a battery in a defined period,
   c) reading (S3) instantaneous values of calendar ageing wearing coefficient $BWC_1$ and/or instantaneous values of cycle ageing wearing coefficient $BWC_2$, corresponding to instantaneous values of SoC and C-rate of a battery acquired in step (S2), using characteristics of ageing wearing coefficients acquired in step (S1) and
   d) determining (S4):

   - value of calendar ageing wearing index $BWI_1$ by referring integrated instantaneous values of $BWC_1$ determined in step (S3) to the integrated nominal values of $BWC_1$ for a period of nominal operation time with maximum allowable value of the SoC, and/or
   - values of cycle ageing wearing index $BWI_2$ by referring integrated instantaneous values of $BWC_2$ determined in step (S3) to the integrated nominal values of $BWC_2$ for full battery charging or discharging with nominal C-rate thereby indicating degree of battery degradation.

2. Method according to claims 1 **characterized in that** it further comprises a step of determining (S5) a total current value of battery wearing index BWI according to equation (8),

$$BWI = [k \cdot BWI_1 + (1 - k) \cdot BWI_2] \qquad (8)$$

   wherein:

   k - weight of calendar ageing wearing index $BWI_1$ (for $0 < k < 1$ )
   (1-k) - weight of calendar ageing wearing index $BWI_2$.

3. Method according to claim 1 or 2 **characterized in that** instantaneous values of SoC and C-rate of a battery are acquired (S2) from predicted SoC and C-rate profiles based on the historical data.

4. Method according to any of claims 1 to 3 **characterized in that** characteristics of calendar ageing wearing coefficient $BWC_1$ and/or characteristics of cycle ageing wearing coefficient $BWC_2$ are frequently updated.

5. Method according to any of claims 1 to 4 **characterized in that** characteristics of calendar ageing wearing coefficient $BWC_1$ and/or characteristics of cycle ageing wearing coefficient $BWC_2$ are tuned using ML algorithms, wherein historical data of the battery operation is used as input data for ML algorithms.

6. Method according to any of claims 1 to 5 **characterized in that**, the characteristics of calendar ageing wearing coefficient $BWC_1$ and characteristics of cycle ageing wearing coefficient $BWC_2$ of the battery are determined based on battery parameters declared by battery manufacturer.

7. Method according to any one of claims 1 to 6 wherein the steps of the method being performed by means of a processing employing artificial intelligence and/or machine learning techniques and/or at least one trained algorithm.

8. Method according to any one of claims 1 to 7 wherein said method is employed for estimating battery degradation of a Li-Ion battery.

9. Method according to any one of claims 1 to 8 wherein said method is employed for estimating battery degradation of a battery energy storage system, BESS.

10. Method according to claim 9 wherein the step of acquiring (S1) battery parameters also acquiring operating parameters of a battery energy storage system, BESS.

11. A computer program comprising means of program code for performing all steps of the computer-implemented method according to any one of claims 1 to 10, when the said program is running on the computer.

12. A computer-readable medium storing computer-implemented instructions performing all steps of the computer-implemented method according to any one of claims 1 to 11 implemented on the computer.

**Patentansprüche**

1. Computer-implementiertes Verfahren zur Abschätzung der Batteriedegradation, insbesondere der Batterie in einem Batterie-Energiespeichersystem (BESS), das die folgenden Schritte umfasst:

a) Erfassen (S1) von Batterieparametern einer Batterie, Charakteristika des Kalenderalterungsverschleißkoeffizienten $BWC_1$ und/oder Charakteristika des Zyklusalterungsverschleißkoeffizienten $BWC_2$ , wobei $BWC_1$ eine Funktion des Ladezustands SoC und $BWC_2$ eine Funktion der Lade-/Entladerate C-Rate ist,
b) Erfassen und/oder Berechnen (S2) von Momentanwerten von SoC und C-Rate einer Batterie in einem bestimmten Zeitraum,
c) Ablesen (S3) von Momentanwerten des Kalenderalterungsverschleißkoeffizienten $BWC_1$ und/oder von Momentanwerten des Zyklusalterungsverschleißkoeffizienten $BWC_2$, die den in Schritt (S2) erfassten Momentanwerten von SoC und C-Rate einer Batterie entsprechen, unter Verwendung von Charakteristika von in Schritt (SI) erfassten Alterungsverschleißkoeffizienten und
d) Bestimmen (S4):

- des Wertes des Kalenderalterungsverschleißindexes $BWI_1$ durch Bezugnahme der in Schritt (S3) ermittelten integrierten Momentanwerte von $BWC_1$ auf die integrierten Nennwerte von $BWC_1$ für einen Zeitraum der Nennbetriebszeit mit maximal zulässigem Wert der SoC, und/oder
- des Wertes des Zyklusalterungsverschleißindexes $BWI_2$ durch Bezugnahme der in Schritt (S3) ermittelten integrierten Momentanwerte von $BWC_2$ auf die integrierten Nennwerte von $BWC_2$ for für eine vollständige Batterieladung oder -entladung mit Nenn-C-Rate wodurch der Grad der Batteriedegradation angezeigt wird.

2. Verfahren nach Anspruch 1, **dadurch gekennzeichnet, dass** es ferner einen Schritt der Bestimmung (S5) eines Gesamtstromwertes des Batterieverschleißindexes BWI gemäß Gleichung (8) umfasst,

$$BWI = [k * BWI_1 + (1-k) * BWI_2] \qquad (8)$$

wobei:

k - Gewicht des Kalenderalterungsverschleißindexes $BWI_1$ (für 0 < k < 1)
(1-k) - Gewicht des Kalenderalterungsverschleißindexes $BWI_2$.

3. Verfahren nach Anspruch 1 oder 2, **dadurch gekennzeichnet, dass** Momentanwerte von SoC und C-Rate einer Batterie aus vorhergesagten SoC- und C-Rate-Profilen auf der Grundlage der historischen Daten ermittelt werden (S2).

4. Verfahren nach einem der Ansprüche 1 bis 3, **dadurch gekennzeichnet, dass** die Charakteristika des Kalenderalterungsverschleißkoeffizienten $BWC_1$ und/oder die Charakteristika des Zyklusalterungsverschleißkoeffizienten $BWC_2$ häufig aktualisiert werden.

5. Verfahren nach einem der Ansprüche 1 bis 4, **dadurch gekennzeichnet, dass** die Charakteristika des Kalenderalterungsverschleißkoeffizienten $BWC_1$ und/oder die Charakteristika des Zyklusalterungsverschleißkoeffizienten $BWC_2$ unter Verwendung von ML-Algorithmen abgestimmt werden, wobei historische Daten des Batteriebetriebs als Eingangsdaten für ML-Algorithmen verwendet werden.

6. Verfahren nach einem der Ansprüche 1 bis 5, **dadurch gekennzeichnet, dass** die Charakteristika des Kalenderalterungsverschleißkoeffizienten $BWC_1$ und die Charakteristika des Zyklusalterungsverschleißkoeffizienten $BWC_2$ der Batterie auf der Grundlage der vom Batteriehersteller angegebenen Batterieparameter bestimmt werden.

7. Verfahren nach einem der Ansprüche 1 bis 6, wobei die Schritte des Verfahrens mit Hilfe einer Verarbeitung durchgeführt werden, die künstliche Intelligenz und/oder maschinelle Lerntechniken und/oder mindestens einen trainierten Algorithmus verwendet.

8. Verfahren nach einem der Ansprüche 1 bis 7, wobei das Verfahren zur Abschätzung der Batteriedegradation einer Li-Ionen-Batterie verwendet wird.

9. Verfahren nach einem der Ansprüche 1 bis 8, wobei das Verfahren zur Abschätzung der Batteriedegradation eines Batterie-Energiespeichersystems (BESS) eingesetzt wird.

10. Verfahren nach Anspruch 9, wobei der Schritt des Erfassens (S1) von Batterieparametern auch das Erfassen von Betriebsparametern eines Batterie-Energiespeichersystems (BESS) umfasst.

11. Ein Computerprogramm, das einen Programmcode zur Durchführung aller Schritte des computerimplementierten Verfahrens nach einem der Ansprüche 1 bis 10 enthält, wenn das Programm auf dem Computer ausgeführt wird.

12. Ein computerlesbares Medium, auf dem computerimplementierte Befehle gespeichert sind, die alle Schritte des computerimplementierten Verfahrens nach einem der Ansprüche 1 bis 11 auf dem Computer ausführen.

## Revendications

1. Un procédé mis en oeuvre par ordinateur pour estimer la dégradation d'une batterie, en particulier d'une batterie dans un système de stockage d'énergie par batterie, BESS, comprenant les étapes suivantes:

   a) l'acquisition (S1) des paramètres d'une batterie, des caractéristiques du coefficient d'usure de vieillissement calendaire $BWC_1$ et/ou des caractéristiques du coefficient d'usure de vieillissement cyclique $BWC_2$, $BWC_1$ étant une fonction de l'état de charge, SoC, et $BWC_2$ étant une fonction de charge/décharge -taux, taux C,
   b) l'acquisition et/ou le calcul (S2) des valeurs instantanées de SoC et de taux C d'une batterie dans une période définie,
   c) lecture (S3) des valeurs instantanées du coefficient d'usure de vieillissement calendaire $BWC_1$ et/ou des valeurs instantanées du coefficient d'usure de vieillissement cyclique $BWC_2$, correspondant aux valeurs instantanées de SoC et de taux C d'une batterie acquises à l'étape (S2), à l'aide des caractéristiques des coefficients d'usure de vieillissement acquises à l'étape (SI), et
   d) la détermination (S4):

   - de la valeur de l'indice d'usure de vieillissement calendaire $BWI_1$ en référant les valeurs instantanées intégrées de $BWC_1$ déterminées à l'étape (S3) aux valeurs nominales intégrées de $BWC_1$ pour une période de temps de fonctionnement nominal avec une valeur maximale admissible du SoC, et/ou
   - des valeurs de l'indice d'usure de vieillissement cyclique $BWI_2$ en référant les valeurs instantanées intégrées de $BWC_2$ déterminées à l'étape (S3) aux valeurs nominales intégrées de $BWC_2$ pour une charge ou une décharge complète de la batterie avec le taux C nominal,

   indiquant ainsi le degré de dégradation de la batterie.

2. Le procédé selon la revendication 1 **caractérisé en ce qu'**il comprend en outre une étape de détermination (S5) d'une valeur totale actuelle de l'indice d'usure de batterie BWI selon l'équation (8),

$$BWI = [k * BWI_1 + (1-k) * BWI_2] \qquad (8)$$

dans laquelle:

k - poids de l'indice d'usure de vieillissement calendaire $BWI_1$ (pour $0 < k < 1$)

(1-k) - poids de l'indice d'usure de vieillissement calendaire $BWI_2$.

3. Le procédé selon la revendication 1 ou 2 **caractérisé en ce que** les valeurs instantanées de SoC et de taux C d'une batterie sont acquises (S2) à partir des profils prédits de SoC et de taux C sur la base des données historiques.

4. Le procédé selon l'une des revendications 1 à 3, **caractérisé en ce que** les caractéristiques du coefficient d'usure de vieillissement calendaire $BWC_1$ et/ou les caractéristiques du coefficient d'usure de vieillissement cyclique $BWC_2$ sont fréquemment mises à jour.

5. Le procédé selon l'une des revendications 1 à 4, **caractérisé en ce que** les caractéristiques du coefficient d'usure de vieillissement calendaire $BWC_1$ et/ou les caractéristiques du coefficient d'usure de vieillissement cyclique $BWC_2$ sont ajustées à l'aide d'algorithmes ML, les données historiques du fonctionnement de la batterie étant utilisées comme données d'entrée pour les algorithmes ML.

6. Le procédé selon l'une des revendications 1 à 5, **caractérisé en ce que** les caractéristiques du coefficient d'usure de vieillissement calendaire $BWC_1$ et les caractéristiques du coefficient d'usure de vieillissement cyclique $BWC_2$ de la batterie sont déterminées sur la base des paramètres de batterie déclarés par le fabricant de la batterie.

7. Le procédé selon l'une des revendications 1 à 6, dans lequel les étapes du procédé sont exécutées au moyen d'un traitement utilisant des techniques d'intelligence artificielle et/ou d'apprentissage automatique et/ou au moins un algorithme entraîné.

8. Le procédé selon l'une des revendications 1 à 7, dans lequel ledit procédé est utilisé pour estimer la dégradation d'une batterie Li-Ion.

9. Le procédé selon l'une quelconque des revendications 1 à 8, dans lequel ledit procédé est utilisé pour estimer la dégradation d'une batterie d'un système de stockage d'énergie par batterie, BESS.

10. Le procédé selon la revendication 9, dans lequel l'étape d'acquisition (S1) des paramètres de batterie consiste également à acquérir les paramètres de fonctionnement d'un système de stockage d'énergie par batterie (BESS).

11. Un programme d'ordinateur comprenant des moyens de code de programme pour exécuter toutes les étapes du procédé mis en oeuvre par ordinateur selon l'une quelconque des revendications 1 à 10, lorsque ledit programme est exécuté sur l'ordinateur.

12. Un support lisible par ordinateur stockant des instructions mises en oeuvre par ordinateur et exécutant toutes les étapes du procédé mis en oeuvre par ordinateur selon l'une des revendications 1 à 11 mises en oeuvre sur l'ordinateur.

```
┌────────────────────────────────────────────┐
│           Mechanisms of battery ageing      │
└────────────────────────────────────────────┘
         │                              │
         ▼                              ▼
┌──────────────────────┐      ┌──────────────────────┐
│    Calendar ageing   │      │     Cycle ageing     │
└──────────────────────┘      └──────────────────────┘
         │                              │
         ▼                              ▼
┌──────────────────────┐      ┌──────────────────────┐
│ Related to battery   │      │  Related to C-rate   │
│ life over time and   │      │  and frequency of    │
│ Soc rate frequency   │      │       usage          │
└──────────────────────┘      └──────────────────────┘
         │                              │
         ▼                              ▼
┌──────────────────────┐      ┌──────────────────────┐
│ BWI₁ calculated on   │      │ BWI₂ calculated on   │
│       BWC₁           │      │       BWC₂           │
└──────────────────────┘      └──────────────────────┘
```

$BWI_1$ calculated on $BWC_1$

$BWI_2$ calculated on $BWC_2$

**Fig. 1**

**S1** **Acquiring:**
- battery parameters of a battery,
- characteristics of calendar ageing wearing coefficient $BWC_1$ and/or characteristics of cycle ageing wearing coefficient $BWC_2$ wherein $BWC_1=f(SoC)$ and $BWC_2=f(C\text{-rate})$

**S2** **Acquiring:**
- instantaneous values of SoC and C-rate of a battery in a defined period

**S3** **Reading:**
- instantaneous values of calendar ageing wearing coefficient $BWC_1$, and/or
- instantaneous values of cycle ageing wearing coefficient $BWC_2$
- corresponding to instantaneous values of SoC and C-rate of a battery acquired in step (S2), using characteristics of ageing wearing coefficients acquired in step (S1)

**S4** **Determining:**
- value of calendar ageing wearing index **BWI₁** by referring integrated instantaneous values of **BWC₁** determined in step (S3) to the integrated instantaneous values of **BWC₁** for a period of nominal operation time with maximum allowable value of the SoC, and/or
- values of cycle ageing wearing index **BWI₂** by referring integrated instantaneous values of **BWC₂** determined in step (S3) to the integrated values of **BWC₂** for full battery charging (from $SoC_{min}$ to $SoC_{max}$) or discharging (from $SoC_{max}$ to $SoC_{min}$) with nominal C-rate

**thereby indicating degree of battery**

**S5** **Determining** a total current value of battery wearing index **BWI**

**Fig. 2**

## BWC$_1$ = f(SoC)

$y = a_1 (-x$

$[x1, y1$

$[x2,$

$[p, q$

$y = a_2 (x$

SoC - State of Charge

BWC$_1$

**Fig. 3**

## BWC$_2$ = f(C-rate)

$y = a (x)^{alfa}$

$[x, y]$

$[p, q$

C-rate of Charge

BWC$_2$

**Fig. 4**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 111753416 A
- EP 3824305 A1
- US 20170115358 A1
- WO 2021044134 A1
- EP 3531149 A4
- EP 3273523 B1